# EUROPEAN PATENT APPLICATION

(11) **EP 2 398 256 A2**
(43) Date of publication of application: **21.12.2011**
(21) Application number: 11169810.6
(22) Date of filing: 14.06.2011
(51) Int. Cl.: H04R 29/00, H03G 3/00, H03G 1/02, H04N 5/60, H04N 5/44

(54) **Television set and speaker system**

(30) Priority: 18.06.2010 JP 2010138876
(71) Applicant: Funai Electric Co., Ltd., Daito-shi Osaka 574-0013 (JP)
(72) Inventor: Takahashi, Hironobu, Daito-shi, Osaka 574-0013 (JP)
(74) Representative: Grünecker, Kinkeldey, Stockmair & Schwanhäusser

(57) **Abstract**

A television set that transmits in a format based on a serial communication standard for digitally transferring audio, audio data to a speaker device with a built-in amplifier. The television set includes a control code transmission unit that, when an operation tool for effecting a predetermined function of the television set is operated on a remote controller, transmits in the format based on the serial communication standard, a control code corresponding to the predetermined function to the speaker device with the built-in amplifier.

## Description

### BACKGROUND OF THE INVENTION

### 1. Field of the Invention

The present invention relates to a link function between a television set and a speaker device with a built-in amplifier.

### 2. Description of Prior Art

A speaker system is made up of a television set and a speaker device with a built-in amplifier connected to the television set, and various types of such systems have conventionally been developed (see, for example, Japanese Unexamined Patent Application Publication (Translation of PCT Application) No. 2007-052625). Particularly in recent years, a so-called sound bar that is a speaker device with a built-in amplifier having a bar shape in appearance has come into widespread use.

Furthermore, the television set and above-described sound bar of recent years each often include an S/PDIF (Sony/Philips Digital Interface) terminal as a standard feature. S/PDIF is a serial communication standard for digitally transferring audio data. Data transferred in this case is composed of digitally encoded audio data (Dolby Digital, Advanced Audio Coding, etc.) or linear PCM audio data, various additional data such as a copy protect flag, and so on. As types of the S/PDIF terminal, an optical digital audio terminal and a coaxial digital audio terminal have been standardized. Establishing connection between the S/PDIF terminal of the television set and the S/PDIF terminal of the sound bar with one cable allows audio to be digitally transferred from the television set to the sound bar, and thus a user can hear sound from the sound bar.

In such a conventional speaker system made up of a television set and a sound bar, however, the television set and the sound bar are accompanied with dedicated remote controllers, respectively, requiring them to be operated using their respective dedicated remote controllers, which deteriorates convenience and thus has been problematic.

A possible solution to this is to add a so-called link function, which has been widespread in recent years, so that the television set and the sound bar could be operated using a single remote controller. This, however, would require that, in addition to the above-described S/PDIF terminal, a component for establishing linkage such as an IR terminal or an HDMI (High-Definition Multimedia Interface) terminal be additionally included, which incurs a cost increase and thus has been problematic.

### SUMMARY OF THE INVENTION

It is an object of the present invention to provide a television set and a speaker system in compliance with a serial communication standard for digitally transferring audio data, such as S/PDIF, which, while suppressing a cost increase, allow the television set and a speaker device with a built-in amplifier to be operated using a single remote controller and thus provide a high degree of convenience.

A television set according to the present invention transmits in a format based on a serial communication standard for digitally transferring audio, audio data to a speaker device with a built-in amplifier. The television set includes a control code transmission unit that, when an operation tool for effecting a predetermined function of the television set is operated on a remote controller, transmits in the format based on the serial communication standard, a control code corresponding to the predetermined function to the speaker device with the built-in amplifier.

According to this configuration, operating an operation tool on a single remote controller allows a predetermined function to be effected in the television set and the speaker device with the built-in amplifier, and thus a high degree of user's convenience is provided. Furthermore, since a control code is transmitted using a serial communication standard for digitally transferring audio, it is possible to achieve a link function without the need to additionally include any component based on a standard different from that standard and thus can suppress a cost increase.

Furthermore, in the above-described configuration, the predetermined function may be at least one of a power-on function, a power-off function, and a volume adjustment function.

Furthermore, in either of the above-described configurations, the control code transmission unit may transmit the control code for a given period of time. This configuration allows secure transmission of the control code to be confirmed in the speaker device with the built-in amplifier.

Furthermore, any one of the above-described configurations may further include a mute control unit that, when an operation tool for effecting a power-on function of the television set is operated on the remote controller and the control code transmission unit transmits the control code, mutes a speaker included in the television set. According to this configuration, under synchronized power-on control, the speaker in the television set is muted so as to allow a speaker in the speaker device with the built-in amplifier to override the speaker in the television set.

Furthermore, in any one of the above-described configurations, the serial communication standard may be S/PDIF (Sony/Philips Digital Interface).

Furthermore, a speaker system according to the present invention includes: the television set having any one of the above-described configurations; and a speaker device with a built-in amplifier.

### DESCRIPTION OF DRAWINGS

Fig. 1 is a schematic structural view of a speaker system according to one embodiment of the present invention.
Fig. 2 is a flow chart showing an operation of a television set under synchronized power-on control.
Fig. 3 is a flow chart showing an operation of a sound bar under the synchronized power-on control.
Fig. 4 is a flow chart showing an operation of the television set under volume up control.
Fig. 5 is a flow chart showing an operation of the sound bar under the volume up control.
Fig. 6 is a flow chart showing an operation of the television set under synchronized power-off control.
Fig. 7 is a flow chart showing an operation of the sound bar under the synchronized power-off control.
Fig. 8 is a diagram showing an S/PDIF format.

### DESCRIPTION OF PREFERRED EMBODIMENT

Hereinafter, a description is made of an embodiment of the present invention with reference to the appended drawings. The following description uses, as an example, a speaker system made up of a television set capable of receiving digital broadcasts and a sound bar.

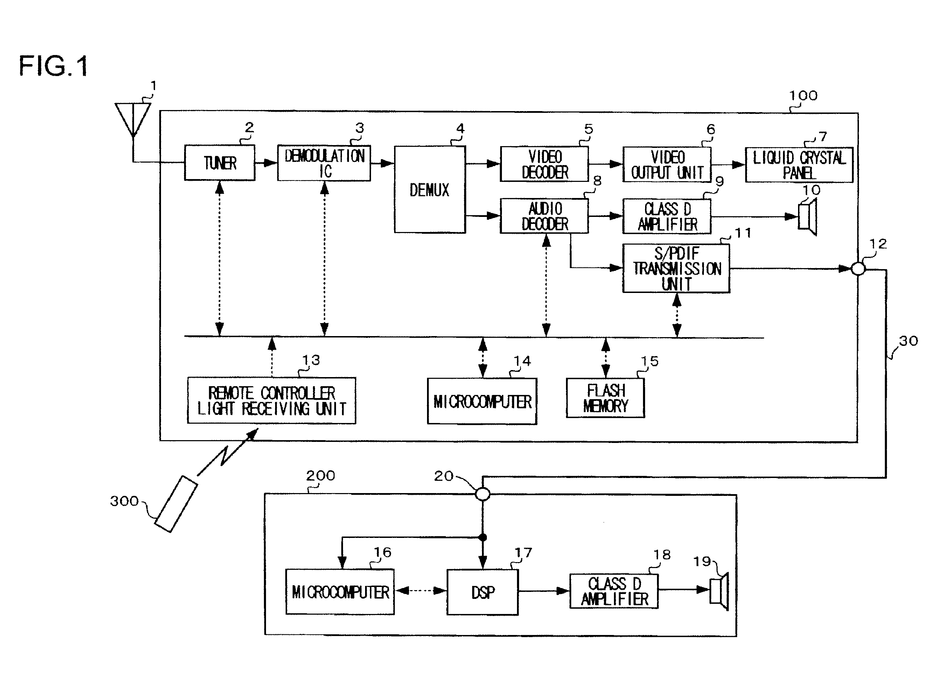

Fig. 1 is a diagram showing a schematic configuration of a speaker system according to one embodiment of the present invention. The speaker system of the present invention is made up of a television set 100 capable of receiving digital broadcasts and a sound bar 200 that is a speaker device with a built-in amplifier.

The television set 100 includes a tuner 2, a demodulation IC 3, a DEMUX (demultiplexer) 4, a video decoder 5, a video output unit 6, a liquid crystal panel 7, an audio decoder 8, a class D amplifier 9, a speaker 10, an S/PDIF transmission unit 11, an S/PDIF terminal 12, a remote controller light receiving unit 13, a microcomputer 14, and a flash memory 15. An antenna 1 is connected to the tuner 2.

Furthermore, the sound bar 200 includes a microcomputer 16, a DSP (digital signal processor) 17, a class D amplifier 18, a speaker 19, and an S/PDIF terminal 20. The S/PDIF terminal 12 and the S/PDIF terminal 20 are connected to each other with a cable 30.

The tuner 2 selects, from among digital broadcast signals received from the antenna 1, a broadcast signal having a frequency of a selected station and outputs the selected broadcast signal to the demodulation IC 3. With respect to the broadcast signal received, the demodulation IC 3 performs demodulation using an OFDM (orthogonal frequency division multiplexing) method and error correction using Viterbi decoding or the like and extracts TS (transport stream) data therefrom.

The DEMUX 4 extracts video stream data from the TS data and outputs the video stream data to the video decoder 5. The DEMUX 4 also extracts audio stream data from the TS data and outputs the audio stream data to the audio decoder 8.

The video decoder 5 decodes the video stream data and outputs digital video data to the video output unit 6. The video output unit 6 converts the digital video data into a video signal in a format adapted for display on the liquid crystal panel 7 and outputs the video signal to the liquid crystal panel 7. The liquid crystal panel 7 displays an image based on the video signal inputted from the video output unit 6.

The audio decoder 8 decodes the audio stream data and transmits digital audio data to the class D amplifier 9 or the S/PDIF transmission unit 11. The class D amplifier 9 generates a driving signal for the speaker 10 based on the digital audio data and thus drives the speaker 10.

The S/PDIF transmission unit 11 generates S/PDIF format data composed of digital audio data, additional data, and so on and transmits the generated SIPDIF format data to the sound bar 200 via the S/PDIF terminal 12 and the cable 30. As the S/PDIF terminal 12, an optical digital audio terminal or a coaxial digital audio terminal is used (the same applies to the S/PDIF terminal 20).

The remote controller light receiving unit 13 receives, from a remote controller 300, an infrared signal corresponding to a key operation performed and converts the received infrared signal into a remote controller code. The remote controller 300 is provided with various keys such as a power key, a volume up key, and a volume down key.

The microcomputer 14 is made up of a CPU, a ROM, and so on and performs overall control of the television set 100. The flash memory 15 is a rewritable involatile memory, and configuration information and the like are stored therein.

Furthermore, in the sound bar 200, the DSP 17 extracts audio data from the S/PDIF format data received via the S/PDIF terminal 20 and, after making volume (sound level) adjustment to the extracted audio data, outputs the audio data to the class D amplifier 18. The class D amplifier 18 generates a driving signal for the speaker 19 based on the audio data and thus drives the speaker 19. The microcomputer 16 mainly performs power control of the sound bar 200.

Next, the following describes a link function achieved in the speaker system according to the present invention.

### (Synchronized Power-on Control)

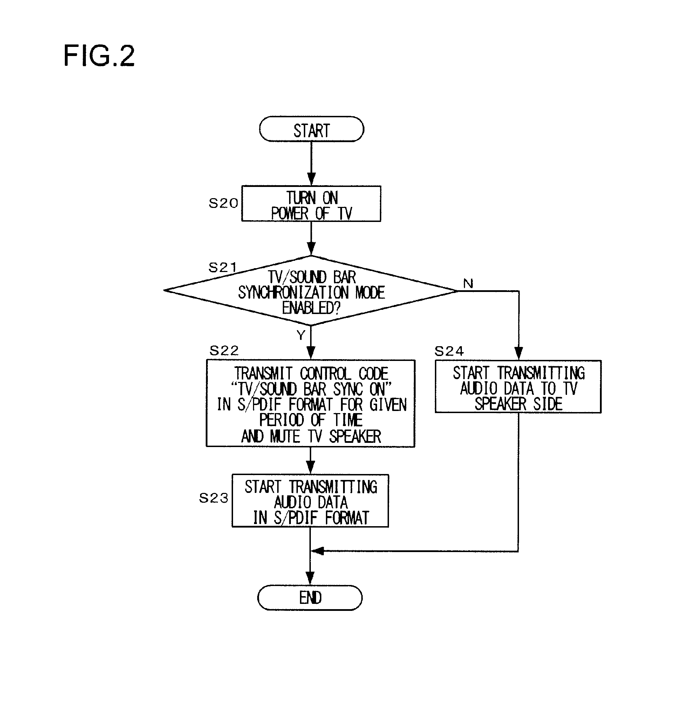

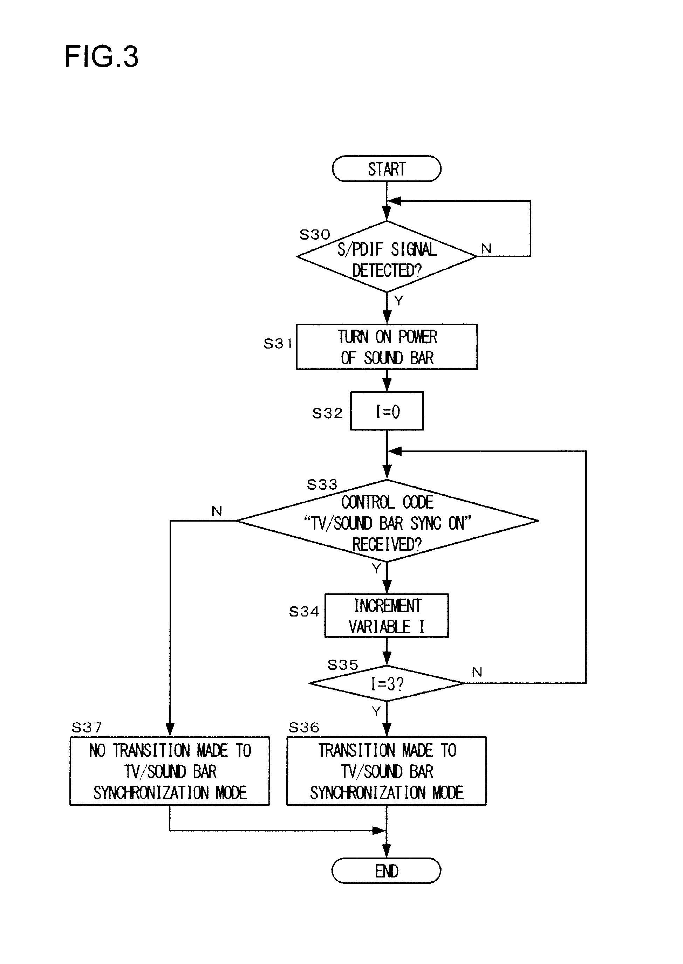

Herein described is synchronized power-on control performed in the speaker system according to the present invention. Fig. 2 shows an operation of the television set 100 under the synchronized power-on control, and Fig. 3 shows an operation of the sound bar 200 under the synchronized power-on control.

First, when a power-on operation is performed using the power key on the remote controller 300 and the microcomputer 14 on standby receives a remote controller code corresponding to the power key from the remote controller light receiving unit 13, the operation shown in the flow chart of Fig. 2 is started, and at step S20, the microcomputer 14 turns on the power of the television set 100. Next, at step S21, the microcomputer 14 determines whether or not a TV/sound bar synchronization mode is in an enabled state.

The TV/sound bar synchronization mode may be set, for example, in such a manner that every time a dedicated key provided on the remote controller 300 is operated, the TV/sound bar synchronization mode is switched between an enabled state and a disabled state. Alternatively, the TV/sound bar synchronization mode may be set, for example, in such a manner that a function of setting the TV/sound bar synchronization mode is included in an OSD (on-screen display) menu so that the TV/sound bar synchronization mode can be set to be in an enabled state or a disabled state on an OSD screen.

If the TV/sound bar synchronization mode is in an enabled state ("Y" in step S21), an advance is made to step S22 where, by a command from the microcomputer 14, the S/PDIF transmission unit 11 transmits in an S/PDIF format, a control code "TV/SOUND BAR SYNC ON" to the sound bar 200 for a given period of time.

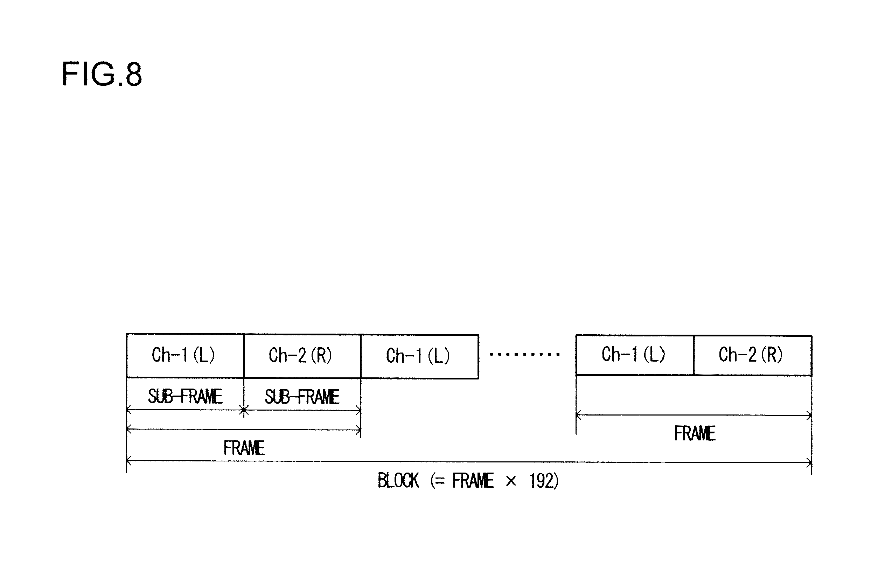

Herein, reference is made to Fig. 8 showing an S/PDIF format. The minimum data unit in the S/PDIF format is referred to as a sub-frame, which is represented by data of Ch-1 (L-ch) or Ch-2 (R-ch). Two sub-frames form a frame, and 192 frames are grouped together into a block.

A sub-frame contains 32 bits, each of which is referred to as a time slot. A sequence of the 9^{th} to 28^{th} time slots from the head time slot is used for audio data. Furthermore, the 31^{st} time slot from the head time slot is referred to as a channel status, and bits corresponding to this time slot of one bit, which are contained in one block, i.e. 192 bits are grouped together and handled as data of 24 bytes in total. An undefined region contained in these channel statuses of 24 bytes is used for transmission of the above-described control code "TV/SOUND BAR SYNC ON". This region is used also for transmission of after-mentioned other control codes.

Transmitting the control code "TV/SOUND BAR SYNC ON" for a given period of time as described above refers to transmitting one block of data containing the control code a predetermined number of times repeatedly.

Also at step S22, concurrently with the transmission of the control code, the speaker 10 of the television set 100 is muted. This could be achieved by, for example, turning off a transistor switch (not shown) provided upstream of the class D amplifier 9 through control by the microcomputer 14.

Then, at step S23, the S/PDIF transmission unit 11 starts transmitting in the S/PDIF format, audio data transmitted from the audio decoder 8 to the sound bar 200.

If the TV/sound bar synchronization mode is in a disabled state ("N" in step S21), an advance is made to step S24 where the audio decoder 8 starts transmitting audio data to the class D amplifier 9, and thus sound is emitted from the speaker 10.

Furthermore, during this time, the following operation is performed in the sound bar 200. First, at step S30, if the microcomputer 16 on standby, which has been monitoring an input from the S/PDIF terminal 20, detects a signal input ("Y" in step S30), at step S31, the microcomputer 16 turns on the power of the sound bar 200. This starts up the DSP 17.

Next, at step S32, the DSP 17 initializes a variable I to 0. Then, at step S33, the DSP 17 extracts data in a control code region from S/PDIF format data received and determines whether or not the data thus extracted represents the control code "TV/SOUND BAR SYNC ON". If the extracted data represents the control code "TV/SOUND BAR SYNC ON" ("Y" in step S33), an advance is made to step S34 where the DSP 17 increments the variable I. Then, an advance is made to step S35 where the DSP 17 determines whether or not the variable I has reached a value of 3, and if not ("N" in step S35), a return is made to step S33.

If the variable I has reached the value of 3 ("Y" in step S35), an advance is made to step S36 where the DSP 17 makes a transition to the TV/sound bar synchronization mode. Upon the transition, the DSP 17 starts extracting audio data from S/PDIF format data inputted from the S/PDIF terminal 20 and, after making volume adjustment to the extracted audio data, transmitting the audio data to the class D amplifier 18. Thus, sound is emitted from the speaker 19.

If, at step S33, it is determined that the extracted data does not represent the control code "TV/SOUND BAR SYNC ON"("N" in step S33), an advance is made to step S37 where the DSP 17 makes no transition to the TV/sound bar synchronization mode.

With the above-described control, when a power-on operation is performed on the remote controller 300, the power of the television set 100 is turned on, and the power of the sound bar 200 is also turned on automatically. Once receipt of the control code "TV/SOUND BAR SYNC ON" is detected three times, the DSP 17 of the sound bar 200 makes a transition to the TV/sound bar synchronization mode, and thus sound can be heard from the speaker 19 of the sound bar 200.

### (Volume Adjustment Control)

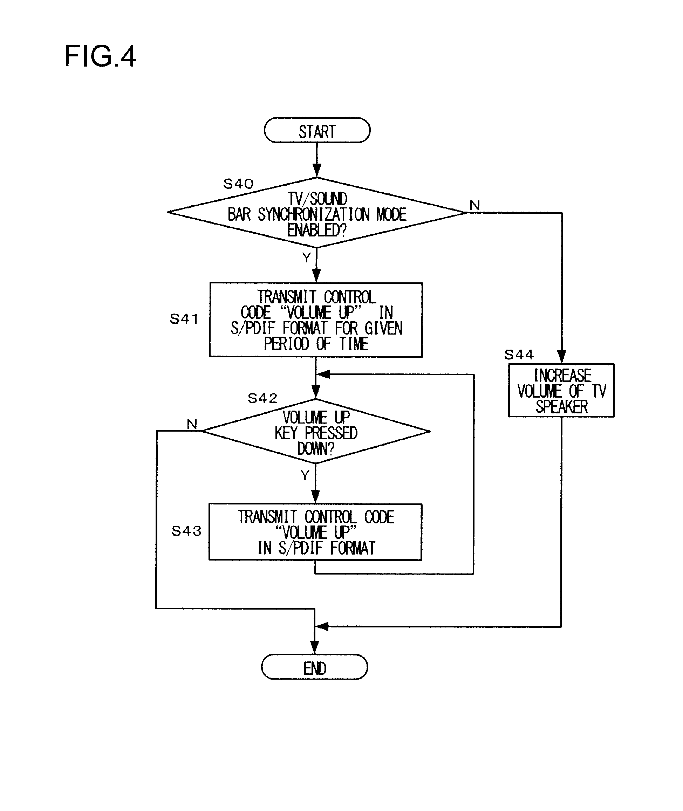

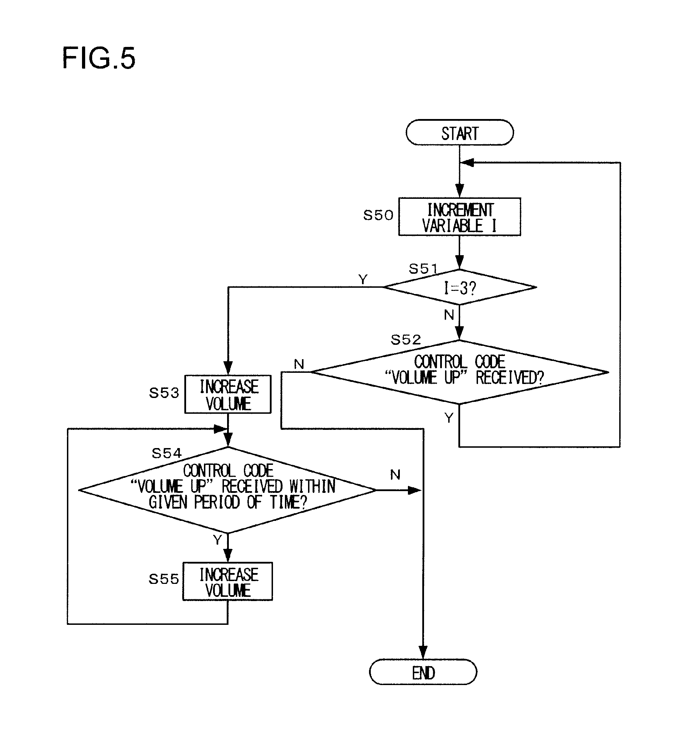

Next, the following describes volume adjustment control performed in the speaker system according to the present invention. In the following, while volume up control is described in detail, volume down control is not described since a similar description applies thereto. Fig. 4 shows an operation of the television set 100 under the volume up control, and Fig. 5 shows an operation of the sound bar 200 under the volume up control.

First, when the volume up key is operated on the remote controller 300 and the microcomputer 14 receives a remote controller code corresponding to the volume up key from the remote controller light receiving unit 13, the operation shown in the flow chart of Fig. 4 is started. At step S40, the microcomputer 14 determines whether or not the TV/sound bar synchronization mode is in an enabled state, and if it is in the enabled state ("Y" in step S40), an advance is made to step S41.

At step S41, by a command from the microcomputer 14, the S/PDIF transmission unit 11 transmits in the S/PDIF format, a control code "VOLUME UP" to the sound bar 200 for a given period of time. In this case, one block of data containing audio data and the control code is transmitted three times.

Then, at step S42, the microcomputer 14 checks whether or not the remote controller code corresponding to the volume up key has been received from the remote controller light receiving unit 13, and if it has been received ("Y" in step S42), at step S43, by a command from the microcomputer 14, the S/PDIF transmission unit 11 transmits in the S/PDIF format, the control code "VOLUME UP" to the sound bar 200. In this case, one block of data containing audio data and the control code is transmitted.

If the remote controller code corresponding to the volume up key has not been received ("N" in step S42), processing is completed ("End").

If the TV/sound bar synchronization mode is in a disabled state ("N" in step S40), an advance is made to step S44 where the audio decoder 8 makes volume up adjustment to audio data, and thus sound at an increased volume is emitted from the speaker 10.

Furthermore, in the sound bar 200, upon a transition to the TV/sound bar synchronization mode, the DSP 17 extracts data in a control code region from S/PDIF format data inputted from the S/PDIF terminal 20 and determines whether or not the data thus extracted represents a predetermined control code. If the extracted data represents the control code "VOLUME UP", the DSP 17 initializes a variable I to 0, and the operation shown in the flow chart of Fig. 5 is started.

First, at step S50, the DSP 17 increments the variable I and at step S51, determines whether or not the variable I has reached a value of 3. If the variable I has not reached the value of 3 ("N" in step S51), an advance is made to step S52 where the DSP 17 extracts data in a control code region from S/PDIF format data inputted from the S/PDIF terminal 20 and determines whether or not the data thus extracted represents the control code "VOLUME UP". If the extracted data represents the control code "VOLUME UP" ("Y" in step S52), a return is made to step S50.

If the variable I has reached the value of 3 ("Y" in step S51), an advance is made to step S53 where the DSP 17 makes volume up adjustment, and then an advance is made to step S54. At step S54, if, within a predetermined period of time, the DSP 17 extracts data in a control code region from S/PDIF format data inputted from the S/PDIF terminal 20 and determines that the data thus extracted represents the control code "VOLUME UP" ("Y" in step S54), an advance is made to step S55 where the DSP 17 makes volume up adjustment, and then a return is made to step S54.

Furthermore, if, at step S52, it is determined that the extracted data does not represent the control code "VOLUME UP" ("N" in step S52) or if, at step S54, a determination that the extracted data represents the control code "VOLUME UP" cannot be made within the predetermined period of time ("N" in step S54), processing is completed ("End").

With the above-described control, when the volume up key is operated on the remote controller 300, the control code "VOLUME UP" is transmitted from the television set 100 to the sound bar 200 for a given period of time, and once receipt of the control code "VOLUME UP" is detected three times in the sound bar 200, sound at an increased volume is emitted from the speaker 19. If the volume up key continues to be operated, the transmission of the control code "VOLUME UP" is continued, thus bringing about a gradual volume increase in the sound bar 200.

Furthermore, if the volume up key is operated intermittentl y, at the time the operation is performed for the first time, the control code "VOLUME UP" is transmitted for a given period of time, and once receipt of the control code "VOLUME UP" is detected three times in the sound bar 200, sound at an increased volume is emitted from the speaker 19. At the time the operation is performed for the second time, the control code "VOLUME UP" is again transmitted for a given period of time, so that, in the sound bar 200, receipt of the control code "VOLUME UP" is detected within a predetermined period of time, thus bringing about a further volume increase. A similar description also applies to the times the operation is performed for the third and subsequent times, thus bringing about a gradual volume increase.

Volume down control could be performed similarly using the volume down key and a control code ``VOLUME DOWN" instead of the volume up key and the control code "VOLUME UP" used in the above-described volume up control, respectively.

### (Synchronized Power-off Control)

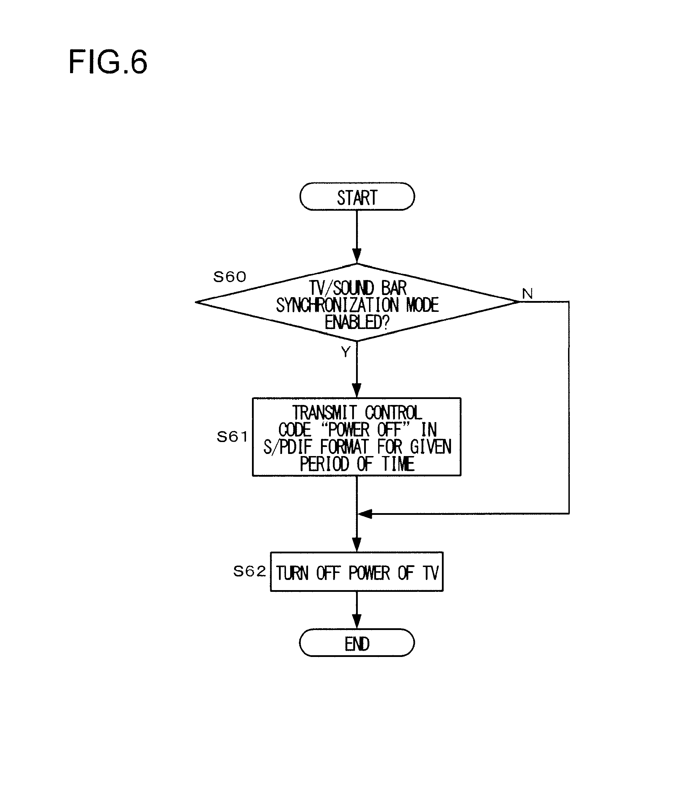

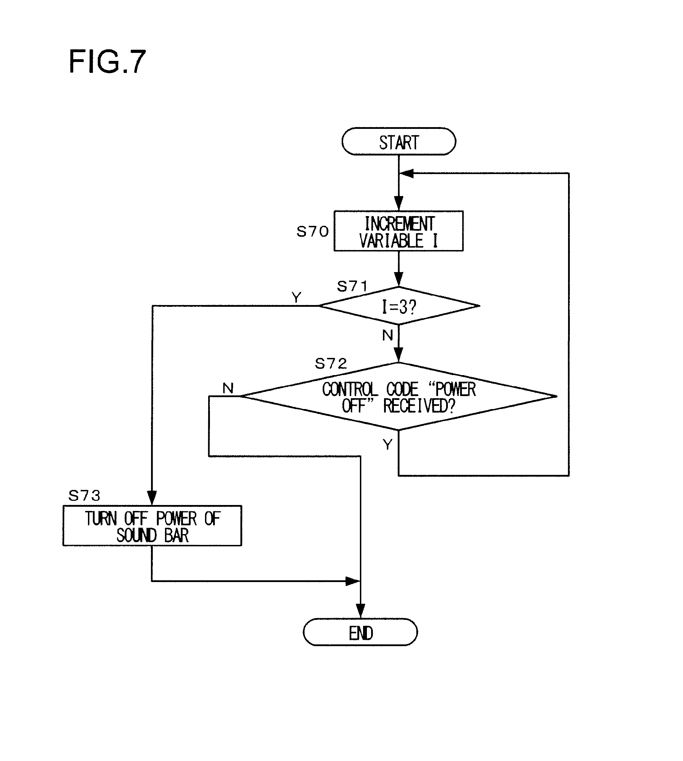

Next, the following describes synchronized power-off control performed in the speaker system according to the present invention. Fig. 6 shows an operation of the television set 100 under the synchronized power-off control, and Fig. 7 shows an operation of the sound bar 200 under the synchronized power-off control.

When a power-off operation is performed using the power key on the remote controller 300 and the microcomputer 14 receives the remote controller code corresponding to the power key from the remote controller light receiving unit 13, the operation shown in the flow chart of Fig. 6 is started.

First, at step S60, the microcomputer 14 determines whether or not the TV/sound bar synchronization mode is in an enabled state, and if it is in the enabled state ("Y" in step S60), an advance is made to step S61 where, by a command from the microcomputer 14, the S/PDIF transmission unit 11 transmits in the S/PDIF format, a control code "POWER OFF" to the sound bar 200 for a given period of time. In this case, one block of data containing audio data and the control code is transmitted three times. Then, at step S62, the microcomputer 14 turns off the power of the television set 100 and processing thus is completed ("End").

Furthermore, if the TV/sound bar synchronization mode is in a disabled state ("N" in step S60), an advance is made to step S62, so that, without any further steps taken, the power of the television set 100 is turned off and processing thus is completed ("End").

Furthermore, in the sound bar 200, upon a transition to the TV/sound bar synchronization mode, the DSP 17 extracts data in a control code region from S/PDIF format data inputted from the S/PDIF terminal 20 and determines whether or not the data thus extracted represents a predetermined control code. In this case, if the extracted data represents the control code "POWER OFF", the DSP 17 initializes a variable I to 0, and the operation shown in the flow chart of Fig. 7 is started.

First, at step S70, the DSP 17 increments the variable I and at step S71, determines whether or not the variable I has reached a value of 3. If the variable I has not reached the value of 3 ("N" in step S71), an advance is made to step S72 where the DSP 17 extracts data in a control code region from S/PDIF format data inputted from the S/PDIF terminal 20 and determines whether or not the data thus extracted represents the control code "POWER OFF". If the extracted data represents the control code "POWER OFF" ("Y" in step S72), a return is made to step S70.

If the variable I has reached the value of 3 ("Y" in step S71), an advance is made to step S73 where the DSP 17 issues a command to the microcomputer 16, by which the microcomputer 16 turns off the power of the sound bar 200, and processing thus is completed ("End").

Furthermore, if, at step S72, it is determined that the extracted data does not represent the control code "POWER OFF" ("N" in step S72), without any further steps taken, the processing is completed ("End").

With the above-described control, when a power-off operation is performed using the power key on the remote controller 300, the control code "POWER OFF" is transmitted from the television set 100 to the sound bar 200 for a given period of time, so that the power of the television set 100 is turned off, and once receipt of the control code "POWER OFF" is detected three times in the sound bar 200, the power of the sound bar 200 is turned off automatically.

As discussed in the foregoing description, the use of the single remote controller 300 allows a user to perform synchronized power-on/off operations and a volume adjustment operation with respect to the television set 100 and the sound bar 200, and thus a high degree of convenience is provided. Furthermore, since the control codes are transmitted in the S/PDIF format, it is possible to achieve the link function without additionally including any component based on a standard different from S/PDIF and thus can suppress a cost increase.

The embodiment of the present invention has been described thus far. It is to be noted, however, that the embodiment may be variously modified without departing from the spirit of the present invention.

For example, a configuration is also possible in which in the foregoing synchronized power-on/off control and volume adjustment control, the process steps to be performed by the DSP 17 are performed by the microcomputer 16 (an output of the S/PDIF terminal 20 is not transmitted to the DSP 17). In such a case, the operations could be performed so that audio data is transmitted from the microcomputer 16 to the DSP 17, volume up/down commands are issued from the microcomputer 16 to the DSP 17, and the microcomputer 16 itself turns off the power of the sound bar 200.

Furthermore, the volume up control (Fig. 5) may be performed so that, if, subsequently to step S53, receipt of the control code "VOLUME UP" within a predetermined period of time occurs three times repeatedly, volume up adjustment is made (volume down adjustment is made in a similar manner).

Furthermore, in the foregoing embodiment, receipt of each of the control codes is checked three times. There is, however, no limitation thereto, and receipt of each of the control codes may be checked a predetermined plural number of times.

Furthermore, operations enabled by the use of a single remote controller are not limited to the power-on/off operations and the volume adjustment operation, and, for example, sound quality adjustment (low frequency range amplification, etc.) with respect to a television set and a sound bar may be enabled thereby.

Furthermore, without any limitation to S/PDIF, CP-1201 that is an industry standard for a digital audio interface established by the EIAJ (Electronic Industries Association of Japan) may also be used. In such a case, a control code could be contained in a character string region or an undefined region based on the industry standard. Moreover, a control code may be transmitted using any other standard such as IEEE1394 or USB (Universal Serial Bus).

### SUMMARY OF THE INVENTION

It is an object of the present invention to provide a television set and a speaker system in compliance with a serial communication standard for digitally transferring audio data, such as S/PDIF, which, while suppressing a cost increase, allow the television set and a speaker device with a built-in amplifier to be operated using a single remote controller and thus provide a high degree of convenience.

A television set according to the present invention transmits in a format based on a serial communication standard for digitally transferring audio, audio data to a speaker device with a built-in amplifier. The television set is characterized by including a control code transmission unit that, when an operation tool for effecting a predetermined function of the television set is operated on a remote controller, transmits in the format based on the serial communication standard, a control code corresponding to the predetermined function to the speaker device with the built-in amplifier.

According to this configuration, operating an operation tool on a single remote controller allows a predetermined function to be effected in the television set and the speaker device with the built-in amplifier, and thus a high degree of user's convenience is provided. Furthermore, since a control code is transmitted using a serial communication standard for digitally transferring audio, it is possible to achieve a link function without the need to additionally include any component based on a standard different from that standard and thus can suppress a cost increase.

Furthermore, in the above-described configuration, the predetermined function may be at least one of a power-on function, a power-off function, and a volume adjustment function.

Furthermore, in either of the above-described configurations, the control code transmission unit may transmit the control code for a given period of time. This configuration allows secure transmission of the control code to be confirmed in the speaker device with the built-in amplifier.

Furthermore, any one of the above-described configurations may further include a mute control unit that, when an operation tool for effecting a power-on function of the television set is operated on the remote controller and the control code transmission unit transmits the control code, mutes a speaker included in the television set. According to this configuration, under synchronized power-on control, the speaker in the television set is muted so as to allow a speaker in the speaker device with the built-in amplifier to override the speaker in the television set.

Furthermore, in any one of the above-described configurations, the serial communication standard may be S/PDIF (Sony/Philips Digital Interface).

Furthermore, a speaker system according to the present invention includes: the television set having any one of the above-described configurations; and a speaker device with a built-in amplifier.

## Claims

1. A television set that transmits in a format based on a serial communication standard for digitally transferring audio, audio data to a speaker device with a built-in amplifier, **characterized by** comprising:
a control code transmission unit that, when an operation tool for effecting a predetermined function of the television set is operated on a remote controller, transmits in the format based on the serial communication standard, a control code corresponding to the predetermined function to the speaker device with the built-in amplifier.

2. The television set according to claim I, wherein
the predetermined function is at least one of a power-on function, a power-off function, and a volume adjustment function.

3. The television set according to claim 1 or 2, wherein
the control code transmission unit transmits the control code for a given period of time.

4. The television set according to any one of claims I to 3, further comprising:
a mute control unit that, when an operation tool for effecting a power-on function of the television set is operated on the remote controller and the control code transmission unit transmits the control code, mutes a speaker included in the television set.

5. The television set according to any one of claims **1** to 4, wherein
the serial communication standard is S/PDIF (Sony/Philips Digital Interface).

6. A speaker system, comprising:
the television set according to any one of claims 1 to 5; and
a speaker device with a built-in amplifier.
